# EUROPEAN PATENT APPLICATION

(11) **EP 3 859 047 A1**
(43) Date of publication of application: **04.08.2021**
(21) Application number: 19864570.7
(22) Date of filing: 20.09.2019
(51) Int. Cl.: C23C 14/34

(54) **SPUTTERING TARGET AND METHOD FOR PRODUCING SAME**

(30) Priority: 26.09.2018 JP 2018180531
(71) Applicant: JX Nippon Mining & Metals Corporation, Tokyo 105-8417 (JP)
(72) Inventor: SHONO,Daiki, Kitaibaraki-shi Ibaraki 319-1535 (JP); MURATA,Shuhei, Kitaibaraki-shi Ibaraki 319-1535 (JP); OKABE,Takeo, Kitaibaraki-shi Ibaraki 319-1535 (JP)
(74) Representative: Mewburn Ellis LLP
(86) International application number: PCT/JP2019/037135
(87) International publication number: WO 2020/066956

(57) **Abstract**

Provided is a cylindrical sputtering target made of a metal material, which has reduced particles. The sputtering target includes at least a target material, wherein the target material includes one or more metal elements, and has a crystal grain size of 10 µm or less.

## Description

### FIELD OF THE INVENTION

The present disclosure relates to a sputtering target and a method for producing the same. More particularly, the present disclosure relates to a cylindrical sputtering target and a method for producing the same.

### BACKGROUND OF THE INVENTION

Recently, in a field of semiconductor devices, integration and miniaturization at higher levels are required. For example, when producing semiconductor devices, various thin films are formed. Materials of the thin films include molybdenum, tungsten, and titanium. For the forming of the thin films, sputtering is used.

The principle of sputtering is as follows. First, a high voltage is applied between a substrate and a sputtering target while introducing an inert gas (e.g., an Ar gas) in vacuum. Ionized ions such as Ar+ are then allowed to collide with the sputtering target. An energy of the collision releases atoms in the sputtering target to deposit them on the substrate. The thin film can be thus formed.

A shape of the sputtering target includes a flat plate and a cylindrical shape. Patent Literature 1 discloses a cylindrical sputtering target made of at least one metal selected from the group consisting of aluminum, silver, copper, titanium and molybdenum. Further, Patent Literature 1 discloses a method for producing a cylindrical sputtering target. Specifically, it discloses that for a metal-based sputtering target, a material of the cylindrical sputtering target is extruded, or a central part is hollowed out to form a cylindrical shape, or casting is carried out to form a cylindrical shape.

### CITATION LIST

### Patent Literatures

[Patent Literature 1] Japanese Patent Application Publication No. 2018-053366 A

### SUMMARY OF THE INVENTION

### Technical Problem

As described above, in the field of semiconductor devices, integration and miniaturization at higher levels are required. The generation of particles during sputtering is not desirable as it causes various defects in a product. Therefore, it is an object of the present disclosure to provide a cylindrical sputtering target made of a metal material, which has reduced particles.

### Solution to Problem

As a result of intensive studies, the present inventors have succeeded in producing a cylindrical sputtering target by another approach. More particularly, a metal plate has been bent to form a plurality of circular arcuate materials, and these materials have been further welded to be able to form a cylindrical shape. According to such a method, no unnecessary heat treatment is required. Therefore, it is possible to reduce an amount of coarse crystal grains in the sputtering target after being processed into the cylindrical shape.

In one aspect, the invention that has been completed based on the above findings includes the following inventions:

### (Invention 1)

A cylindrical sputtering target, wherein:
the sputtering target comprises at least a target material;
the target material comprises one or more metal elements; and
the target material has a crystal grain size of 10 µm or less.

### (Invention 2)

The sputtering target according to Invention 1, wherein there is at least one joined portion.

### (Invention 3)

The sputtering target according to Invention 2, wherein the joined portion is present in a longitudinal direction of the target.

### (Invention 4)

The sputtering target according to Invention 2 or 3, wherein the joined portion is present in a circumferential direction.

### (Invention 5)

The sputtering target according to any one of Inventions 1 to 4, wherein the metal element is titanium.

### (Invention 6)

A method for producing the sputtering target according to any one of Inventions 1 to 5, comprising the steps of:
bending one or more flat plate materials; and
welding ends of the bent materials.

### (Invention 7)

The method according to Invention 6, wherein the bending comprises bending the one flat plate material to form a cylindrical shape.

### (Invention 8)

The method according to Invention 6, wherein the bending comprises bending the flat plate materials to form a plurality of circular arcuate materials, and
wherein the welding comprises welding the plurality of circular arcuate materials to form a cylindrical shape.

### (Invention 9)

The method according to any one of Inventions 6 to 8, further comprising a step of welding a plurality of cylindrical materials in a longitudinal direction.

### Advantageous Effects of Invention

In one aspect, the sputtering targets according to the present disclosure have a crystal grain size of 10 µm or less. This can allow generation of particles during sputtering to be suppressed.

### BRIEF DESCRIPTION OF THE DRAWINGS

FIG. 1 shows a part of production steps of a cylindrical sputtering target in one embodiment;
FIG. 2 shows a part of production steps of a cylindrical sputtering target in one embodiment;
FIG. 3 shows a structure of a cylindrical sputtering target in one embodiment;
FIG. 4 shows a structure of a cylindrical sputtering target in one embodiment;
FIG. 5 shows a structure of a cylindrical sputtering target in one embodiment; and
FIG. 6 shows a structure of a cylindrical sputtering target in one embodiment.

### DETAILED DESCRIPTION OF THE INVENTION

Hereinafter, specific embodiments for carrying out the invention of the present disclosure will be described. The following descriptions are for facilitating the understanding of the invention according to the present disclosure. That is, they are not intended to limit the scope of the present invention.

### 1. Sputtering Target

### 1-1. Structure

In an embodiment, the invention according to the present disclosure relates to a sputtering target. The sputtering target includes at least a target material, and the target material is a portion to be directly sputtered. Further, the sputtering target may further include a substrate (backing tube). If necessary, a bonding layer may be further provided between the substrate and the target material. Known materials can be used for the substrate and the bonding layer.

In an embodiment, a shape of the sputtering target (and target material) is cylindrical. The size is not particularly limited.

### 1-2. Constituent Elements of Target Material

In an embodiment, the target material is composed of one or more metal elements. Examples of metal elements include, but not limited to, Ti, Nb, Ta, Cu, Co, Mo, W and the like. Further, in addition to one metal element, the target material may be composed of an alloy of a plurality of metal elements. Examples of the alloy include, but not limited to, Ti alloys, Nb alloys, Ta alloys, Cu alloys, Co alloys, Mo alloys, W alloys and the like. Examples of the Ti alloys include, but not limited to, TiAl alloys and TiNb alloys.

When the target material is composed of one metal element (for example, Ti), the purity is 3N (99.9% by mass) or more, and preferably 4N (99.99% by mass) or more, and more preferably 4N5 (99.995% by mass) or more, and even more preferably 5N (99.999% by mass) or more, and most preferably 5N5 (99.9995% by mass) or more. The upper limit may be 8N or less, although not particularly limited thereto. The above purity means a numerical value obtained by composition analysis with glow discharge mass spectrometry (GDMS). For example, in the case of 4N or more, the total amount of elements other than titanium (for example, Na, Al, Si, K, Cr, Mn, Fe, Co, Ni, Cu, Zn, Zr, etc.) is less than 0.01% by mass (100 ppm by mass).

The target material may contain inevitable impurities. Examples of inevitable impurities include O, C and the like. The contents of the impurities is not particularly limited. For example, the content of O may be 1000 ppm by mass or less, and preferably 250 ppm by mass or less, and most preferably 100 ppm by mass or less. For example, the content of C may be 20 ppm by mass or less.

In the target material according to the present disclosure, the reason why the impurity concentration as described above can be achieved is that the target material is not produced by powder sintering (raw material powder is placed in a mold, pressed, and sintered), but instead, the target material is produced using an ingot obtained by a melting method. In the form of powder, the surface area is increased, and more oxygen is incorporated into the raw material powder due to surface oxidation. Therefore, in general, the oxygen concentration in the raw material powder is higher and often exceeds 1000 ppm by mass. Accordingly, the target material formed by powder sintering has a higher oxygen concentration. Further, even if the oxygen concentration in the raw material powder is lower, it is highly probable that the oxygen concentration will be increased due to a step such as pulverization, and it will exceed 1000 ppm by mass. However, the target material according to the present disclosure can avoid an increase in the oxygen concentration, because it employs a method of bending a rolled plate and then welding, in place of the method of powder sintering.

### 1-3. Crystal Grain Size of Target Material

In an embodiment, the metal forming the target material has a specific crystal grain size. More particularly, the crystal grain size is 10 µm or less. Preferably, the crystal grain size is 5 µm or less, and more preferably 1 µm or less. The lower limit of the crystal grain size is typically 0.2 µm or more, although not particularly limited thereto. The crystal grain size of 10 µm or less, i.e., a finer crystal grain size, can allow generation of particles to be suppressed.

The crystal grain size described herein can be obtained by measurement in the following procedure. The crystal grain size is determined from an average line segment length per a crystal grain of a test line that intersects the interior of the crystal grains on a surface (sputtering surface) of the sputtering target in accordance with the intercept method of JIS G 0551: 2013. An optical microscope (region: 200 µm × 200 µm) or the like can be used for observing the crystal grains in this method.

In the target material according to the present disclosure, the reason why the crystal grain size as described above can be achieved is that the target material is not produced by powder sintering, but instead, the target material is produced using the ingot obtained by the melting method. When the powder sintering is carried out, the crystal grain size equivalent to that of the raw material powder grows to a larger crystal grain size by the heat treatment. However, the target material according to the present disclosure can avoid an increase in the crystal grain size, because it employs the method of bending the rolled plate and then welding, in place of the method of the powder sintering.

Further, in the target material according to the present disclosure, another reason why the crystal grain size as described above can be achieved is that the target material is not produced by molding the metal material by an extrusion method, but instread, the target material is produced by using the ingot obtained by the melting method. For the extrusion method, the material is heated for the reasons that the metal material must be melted, and the like. This leads to coarse crystal grains in the material (for example, when the material is Ti, a temperature of the extrusion will be about 1000 °C, leading to crystal grains having several hundred µm). However, the heat treatment is unavoidable for the molding by the extrusion method. The target material according to the present disclosure can avoid an increase in the crystal grain size, because it employs the method of bending the rolled plate and then welding, in place of the extrusion method. Even if the crystal grain size is increased at welded parts, its impact can be local.

### 1-4. Joined Portion of Target Material

In an embodiment, the target material has one or more joined portions. As used herein, the "joined portion" refers to a trace portion in which a plurality of target materials are joined to each other. More particularly, when the structure is observed after etching, a portion where the crystal grains are coarsened by welding or the like to increase the crystal grain size by 20% or more of that of the entire material is referred to as the "joined portion". Here, a method for measuring the grain size of the joined portion is the same as the method for measuring the crystal grain size of the entire material. Further, when verifying the presence of the joined portion, the structure is preferably observed inside the structure (for example, at a position deeper than 2 mm), rather than the surface of the target material. This is because the joined portion observed on the surface of the target material can be eliminated by processing the surface of the target material (for example, by grinding). In this regard, the joined portion inside the target material is not eliminated by the surface processing, so that an accurate determination can be made.

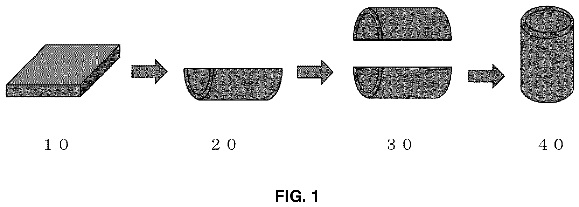

In a further embodiment, the joined portion may be present in the longitudinal direction of the target material. The presence of the joined portion in the longitudinal direction indicates that, as shown in FIG. 1, a cylindrical shape has been formed by bending one or more flat plate materials. When there is one joined portion present in the longitudinal direction, it indicates that a cylinder has been formed by bending one flat plate. When there are plurality of joined portions present in the longitudinal direction, it indicates that a plurality of circular arcuate materials have been formed by bending a number of flat plates corresponding to that of the joined portions. For example, when there are three joined portions present in the longitudinal direction, it indicates that they have been formed by joining three 120° circular arcuate materials. Preferably, there are two joined portions present in the longitudinal direction, because it is the easiest to be produced.

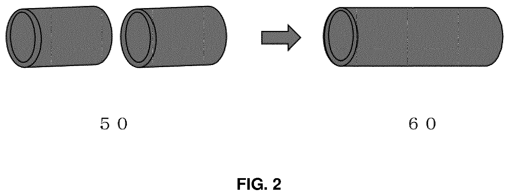

In yet another embodiment, the joined portion may be present in a circumferential direction of the target material. The presence of the joined portion in the circumferential direction indicates that a plurality of cylindrical materials have been connected in the longitudinal direction, as shown in FIG. 2. For example, when there is one joined portion present in the circumferential direction, it indicates that the two cylindrical materials have been connected to each other in the longitudinal direction. Of course, if such joining is not carried out, the joined portion may not be present in the circumferential direction.

A width of the joined portion is not particularly limited in both the circumferential direction and the longitudinal direction, and it may be from 1 mm to 15 mm. The upper limit of the width may be preferably 10 mm or less, and more preferably 5 mm or less. The lower limit of the width may be preferably 2 mm or more, and more preferably 3 mm or more. The width of 10 mm or less can allow any adverse effect of the coarse crystal grains to be minimized. Further, the width of 1 mm or more can allow adhesive strength to be ensured and/or to avoid internal pores.

### 2. Production Method

In an embodiment, the invention according to the present disclosure relates to a method for producing the sputtering target. The method includes at least the following steps:
a step of bending one or more flat plate materials to form a cylindrical shape; and
a step of welding ends of the materials.

The details will be described below.

### 2-1. Flat Plate Material

Hereinafter, descriptions are made with reference to titanium as an example. First, a titanium ingot is prepared by a melting method. The titanium ingot has a purity of 3N (99.9% by mass) or more, and preferably 4N (99.99% by mass) or more, and more preferably 4N5 (99.995% by mass) or more, and further preferably 5N (99.999% by mass) or more, and most preferably 5N5 (99.9995% by mass) or more.

The ingot is then tightened and forged to produce a billet, which is cut to produce flat plate materials. Alternatively, the flat plate materials may be produced by cutting the ingot without tightening and forging the ingot. The flat plate material is then subjected to cold rolling at temperature of room temperature to 400 °C (for example, 300 °C) to be processed into a desired thickness. The cold rolling is carried out at a rolling ratio of from 30% to 95%, and preferably 50% or more, and more preferably 70% or more. The upper limit of the rolling ratio is preferably 90% or less, and more preferably 85% or less. Further, a temperature during rolling is preferably lower than that of the subsequent heat treatment as described later.

After the cold rolling, a heat treatment is carried out. When the rolled plate is heated, a lower heat treatment temperature tends to decrease the crystal grain size. For heat treatment conditions, the temperature is from 200 °C to 550 °C, and preferably 350 °C or more, and more preferably 400 °C or more. The upper limit of the temperature is preferably 550 °C or less, and more preferably 500 °C or less. A heat treatment time is from 0.25 h to 3 h, and preferably 0.25 h or more, and more preferably 0.5 h or more. The upper limit of the heat treatment time is preferably 2 hours or less, and more preferably 1 h or less. By the heat treatment under the above conditions, a flat plate material having desired crystal grains can be obtained.

### 2-2. Bending

The flat plate material can be finished into a rectangle shape (10 in FIG. 1) by appropriately cutting it. The flat plate material is then bent into a circular arcuate shape (20 in FIG. 1). As bending means, known means such as pressing using a cylindrical die can be used.

Further, the ends of the flat plate may be optionally ground before and/or after the bending so that the ends can be joined to other ends without any gap during welding.

An angle when bending the flat plate into the circular arcuate shape is not particularly limited. However, a semicircular shape (i.e., 180°) is preferred. This is because it is easier to be assembled and joined, which will be described later, as compared with the case where the flat plate is bent at another angle.

### 2-3. Joining Method

After obtaining the material bent into the circular arcuate shape by the above method, a plurality of the materials are prepared and assembled into a cylindrical shape. For example, two materials each bent into a semicircle shape are assembled into the cylindrical shape (30 in FIG. 1).

The ends of the materials can be then joined to each other to finish them into an integrated cylindrical shape (40 in FIG. 1). Examples of welding means include, but not limited to, electron beam welding, laser beam welding, and plasma welding. A preferred welding means is the electron beam welding. This is because although heat is applied to the materials during welding, a range affected by the heat can be reduced. Since the range affected by the heat can be reduced, a range where the crystal grains are coarsened can be reduced. The conditions for the electron beam welding are not particularly limited, and welding can be carried out under known conditions.

Also, it should be noted that it is not always necessary to prepare a plurality of flat plate materials in order to assemble them into the cylindrical shape. For example, even if it is one flat plate material, it can be bent so as to go around a cylindrical mold (and the ends are weld) to be processed into the cylindrical shape.

The target material is obtained by the above steps. Since the target material integrates the ends of the materials that are originally present as the flat plates, the joined portion will be present linearly in the longitudinal direction of the cylinder. There are a number of joined portions corresponding to the number of flat plate materials (for example, two joined portions when formed from two flat plate materials).

### 2-4. Assembling in Longitudinal Direction

The bending step and the welding step as described above are repeated to obtain a plurality of cylindrical target materials. The plurality of cylindrical target materials (50 in FIG. 2) may be joined and welded in the longitudinal direction. Thus, a cylindrical target material having an increased size in the longitudinal direction can be obtained (60 in FIG. 2). Further, when the materials are thus welded, the joined portion is formed in the circumferential direction.

### 2-5. Substrate and Bonding Layer

The target material as described above may be bonded to a substrate (a backing tube). This can result in a sputtering target including the substrate and the target material. Further, the joining may be carried out using a brazing material or the like to form a bonding layer between the substrate and the target material.

### 3. Use of Sputtering Target

The sputtering target as described above can be used for thin film formation. Sputtering is used as a means for forming the thin film, but sputtering conditions are not particularly limited, and sputtering can be carried out under conditions set in the art.

### EXAMPLES

### (Example 1)

Two flat plates made of titanium having a purity of 4N5 or more were prepared (each oxygen content was 180 ppm by mass). The grain sizes of these flat plates were measured by observing them with an optical microscope. As a result, each grain size was 8 µm.

These flat plates were then bent into a semicircular shape. The ends were then welded by electron beam welding to form a cylindrical shape.

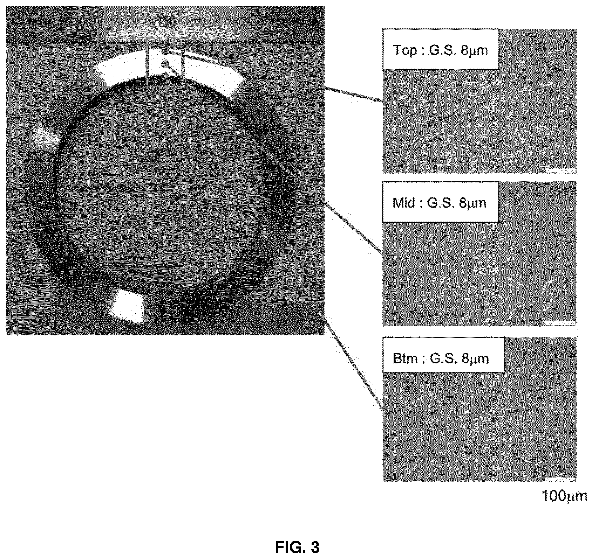

The crystal structures of welded part and non-welded part were then observed with an optical microscope. First, FIG. 3 shows the crystal structure of the non-welded part. The non-welded part had a similar crystal structure on the outside (Top), center (Mid), and inside (Btm) of the thickness. The crystal grain size (G.S) was 8 µm, which was the same as that before the bending. In other words, no influence of the steps after the bending was observed.

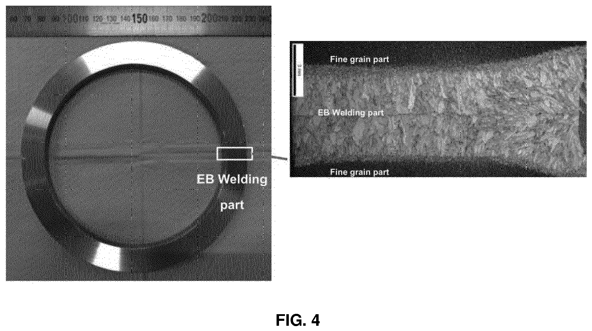

Next, FIG. 4 shows the crystal structure of the welded part. A clear boundary was formed between the fine grain part and the electron beam welding part (EB welding part). The welding part had coarsened crystal grains, as compared with the fine structure.

### (Example 2)

Bending and welding were carried out by the same method as those of Example 1, with the exception that the forging and rolling conditions were appropriately changed, and the flat plate was formed into a cylindrical shape. It should be noted that the flat plate is substantially different from that of Example 1 only in the average grain size.

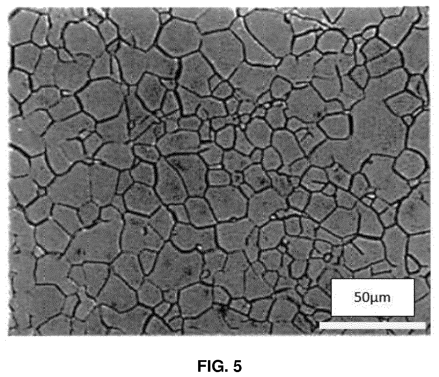

The crystal structure of the non-welded part was then observed with an optical microscope. The crystal structure is shown in FIG. 5. The crystal grain size of the non-welded part was measured by the intercept method in observation with an optical microscope (region: 200 µm × 200 µm) as described above. As a result, the crystal grain size was 9.6 µm, which was the same as that before the bending.

### (Example 3)

Bending and welding were carried out by the same method as those of Example 1, with the exception that the forging and rolling conditions were appropriately changed, and the flat plate was formed into a cylindrical shape. It should be noted that the flat plate is substantially different from that of Example 1 only in the average grain size.

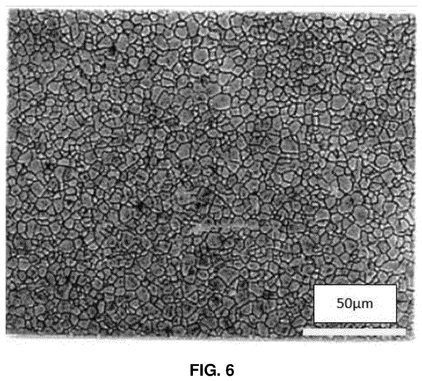

The crystal structure of the non-welded part was then observed with an optical microscope. The crystal structure is shown in FIG. 6. The crystal grain size of the non-welded part was measured by the intercept method in observation with an optical microscope (region: 200 µm × 200 µm) as described above. As a result, the crystal grain size was 4.1 µm, which was the same as that before the bending.

The specific embodiments of the invention according to the present disclosure have been described above. The above embodiments are merely specific examples, and the present invention is not limited to the above embodiments. For example, the technical features disclosed in one of the above embodiments can be applied to other embodiments. Further, unless otherwise specified, it is possible for a specific method to replace some steps with the order of other steps, and an additional step may be added between the two specific steps. The scope of the present invention is defined by the claims.

## Claims

1. A cylindrical sputtering target, wherein:
the sputtering target comprises at least a target material;
the target material comprises one or more metal elements; and
the target material has a crystal grain size of 10 µm or less.

2. The sputtering target according to claim 1, wherein there is at least one joined portion.

3. The sputtering target according to claim 2, wherein the joined portion is present in a longitudinal direction of the target.

4. The sputtering target according to claim 2 or 3, wherein the joined portion is present in a circumferential direction.

5. The sputtering target according to any one of claims 1 to 4, wherein the metal element is titanium.

6. A method for producing the sputtering target according to any one of claims 1 to 5, comprising the steps of:
bending one or more flat plate materials; and
welding ends of the bent materials.

7. The method according to claim 6, wherein the bending comprises bending the one flat plate material to form a cylindrical shape.

8. The method according to claim 6,
wherein the bending comprises bending the flat plate materials to form a plurality of circular arcuate materials, and
wherein the welding comprises welding the plurality of circular arcuate materials to form a cylindrical shape.

9. The method according to any one of claims 6 to 8, further comprising a step of welding a plurality of cylindrical materials in a longitudinal direction.
